(19) **Europäisches Patentamt / European Patent Office / Office européen des brevets**

(11) **EP 3 940 108 A1**

(12) # EUROPEAN PATENT APPLICATION
published in accordance with Art. 153(4) EPC

(43) Date of publication:
**19.01.2022 Bulletin 2022/03**

(21) Application number: **20773930.1**

(22) Date of filing: **12.03.2020**

(51) International Patent Classification (IPC):
**C23C 14/34** (2006.01)   **C04B 35/453** (2006.01)
**H01L 21/285** (2006.01)

(52) Cooperative Patent Classification (CPC):
**C04B 35/453; C23C 14/34; H01L 21/285**

(86) International application number:
**PCT/JP2020/010729**

(87) International publication number:
**WO 2020/189480 (24.09.2020 Gazette 2020/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.03.2019   JP 2019048885**
**06.03.2020   JP 2020039257**

(71) Applicant: **Mitsubishi Materials Corporation**
**Tokyo 100-8117 (JP)**

(72) Inventors:
• **YAMAGUCHI Go**
  **Sanda-shi, Hyogo 669-1339 (JP)**
• **IO Kensuke**
  **Sanda-shi, Hyogo 669-1339 (JP)**
• **KAWAMURA Shiori**
  **Sanda-shi, Hyogo 669-1339 (JP)**
• **UMEMOTO Keita**
  **Sanda-shi, Hyogo 669-1339 (JP)**

(74) Representative: **Hoffmann Eitle**
**Patent- und Rechtsanwälte PartmbB**
**Arabellastraße 30**
**81925 München (DE)**

(54) **TUNGSTEN OXIDE SPUTTERING TARGET**

(57)   A $W_{18}O_{49}$ peak is confirmed by X-ray diffraction analysis of a sputtering surface and a cross section orthogonal to the sputtering surface, a ratio $I_{S(103)}/I_{S(010)}$ of a diffraction intensity $I_{S(103)}$ of a (103) plane to a diffraction intensity $I_{S(010)}$ of a (010) plane of $W_{18}O_{49}$ of the sputtering surface is 0.57 or more, a ratio $I_{C(103)}/I_{C(010)}$ of a diffraction intensity $I_{C(103)}$ of the (103) plane to a diffraction intensity $I_{C(010)}$ of the (010) plane of $W_{18}O_{49}$ of the cross section is 0.38 or less, and an area ratio of the $W_{18}O_{49}$ phase of a surface parallel to the sputtering surface is 37% or more.

FIG. 1

**Description**

[Technical Field]

The present invention relates to a tungsten oxide sputtering target used when forming a tungsten oxide film.
Priority is claimed on Japanese Patent Application Nos. 2019-048885 and 2020-039257, filed March 15, 2019 and March 6, 2020, the contents of which are incorporated herein by reference.

[Background Art]

The tungsten oxide film is used in various fields such as an electrochromic display element and a light-shielding member. In addition, Patent Document 1 discloses that a tungsten oxide film (WOx film) is used as a positive electrode of an organic EL element.
As described in Patent Document 1, the tungsten oxide film described above is formed by a sputtering method using a sputtering target.
As a sputtering target for forming a tungsten oxide film, for example, as shown in Patent Documents 2 and 3, a tungsten oxide sputtering target formed of a sintered body obtained by sintering a tungsten oxide powder is provided.
Patent Document 2 discloses a tungsten oxide sputtering target to which manganese or a manganese compound is added as a sintering aid in order to improve a density of the sintered body.
In addition, Patent Document 3 discloses a tungsten oxide sputtering target formed of a sintered body sintered in a vacuum by using a tungsten oxide powder containing $WO_2$ and at least one of $W_{18}O_{49}$ and $WO_3$, the sintered body having a composition formed of two or more phases of a $WO_2$ phase and a $W_{18}O_{49}$ phase, in order to enable DC sputtering.

[Citation List]

[Patent Documents]

[Patent Document 1] Japanese Unexamined Patent Application, First Publication No. H11-067459
[Patent Document 2] Japanese Unexamined Patent Application, First Publication No. H10-259054
[Patent Document 3] Japanese Unexamined Patent Application, First Publication No. 2013-076163

[Summary of Invention]

[Technical Problem]

Recently, in order to efficiently form a tungsten oxide film, a power higher than that of the related art may be applied to a tungsten oxide sputtering target to form a sputtering film.
In the tungsten oxide sputtering target formed of a sintered body, cracks may occur on a sputtering surface, in a case where the sputtering is performed under high power conditions. In addition, although the cracks do not occur at an initial stage of sputtering, in a case where the sputtering proceeds and a depth of an erosion portion becomes deeper, the cracks tend to easily occur when a high power is applied.
The present invention has been made in view of the above-mentioned circumstances, and an object thereof is to provide a tungsten oxide sputtering target capable of suppressing occurrence of cracks and stably performing sputtering film formation for a long period of time, although the sputtering is performed under high power conditions.

[Solution to Problem]

As a result of intensive studies by the present inventors in order to solve the above problems, the following findings were obtained.
By setting crystal orientation on a sputtering surface and crystal orientation on a cross section orthogonal to the sputtering surface in a predetermined range, it is possible to suppress the occurrence of cracks even when a high power is applied, and it is possible to suppress the occurrence of cracks, even when the sputtering has proceeded. The improvement in hardness of the sputtering surface, by setting the crystal orientation on the sputtering surface and the crystal orientation on the cross section orthogonal to the sputtering surface in the predetermined range, is considered as one reason thereof.
The present invention has been made based on the above findings, and there is provided a tungsten oxide sputtering target of the present invention, in which a $W_{18}O_{49}$ peak is confirmed by X-ray diffraction analysis of a sputtering surface and a cross section orthogonal to the sputtering surface, a ratio $I_{S(103)}/I_{S(010)}$ of a diffraction intensity $I_{S(103)}$ of a (103) plane to a diffraction intensity $I_{S(010)}$ of a (010) plane of $W_{18}O_{49}$ of the sputtering surface is 0.57 or more, a ratio $I_{C(103)}/I_{C(010)}$ of a diffraction intensity $I_{C(103)}$ of the (103) plane to a diffraction intensity $I_{C(010)}$ of the (010) plane of $W_{18}O_{49}$ of the cross section is 0.38 or less, and an area ratio of the $W_{18}O_{49}$ phase of a surface parallel to the sputtering surface is 37% or more.

According to the tungsten oxide sputtering target having this configuration, the $W_{18}O_{49}$ peak is confirmed by the X-ray diffraction analysis on the sputtering surface and the cross section orthogonal to the sputtering surface, and the area ratio of the $W_{18}O_{49}$ phase of the surface parallel to the sputtering surface is 37% or more. Accordingly, it is possible to ensure conductivity and stably perform DC sputtering. In addition, it is possible to ensure the hardness of the tungsten oxide sputtering target.

The ratio $I_{S(103)}/I_{S(010)}$ of the diffraction intensity $I_{S(103)}$ of the (103) plane to the diffraction intensity $I_{S(010)}$ of the (010) plane of $W_{18}O_{49}$ of the sputtering surface is 0.57 or more, the ratio $I_{C(103)}/I_{C(010)}$ of the diffraction intensity $I_{C(103)}$ of the (103) plane to the diffraction intensity $I_{C(010)}$ of the (010) plane of $W_{18}O_{49}$ of the cross section orthogonal to the sputtering surface is 0.38 or less, and the (103) plane of $W_{18}O_{49}$ is strongly oriented on the sputtering surface. Accordingly, it is possible to suppress the occurrence of cracks, although the high power is applied. In addition, even when the sputtering proceeds and the erosion portion is formed, the crystal orientation on the sputtering surface is maintained, and the occurrence of cracks can be suppressed, even when a high power is applied.

The tungsten oxide sputtering target of the present invention preferably has a composition of $WO_X$ ($2.1 \leq X \leq 2.9$).

In this case, since the composition is $WOx$ ($2.1 \leq X \leq 2.9$), the presence of a large amount of $WO_2$ and $WO_3$ phases is suppressed, and it is possible to sufficiently ensure the $W_{18}O_{49}$ phase having high conductivity and more stably perform the DC sputtering. In addition, it is possible to sufficiently ensure the hardness of the tungsten oxide sputtering target.

In addition, it is preferable that, the tungsten oxide sputtering target of the present invention contains an oxide of any one or two or more additive metals of Nb, Ta, Ti, Zr, Y, Al and Si, and as a metal component, in a case where a total amount of the additive metal is defined as M (mass%) and an amount of tungsten is defined as W (mass%), M/(W + M) is in a range of 0.1 or more and 0.67 or less.

In this case, the oxide of any one or two or more additive metals of Nb, Ta, Ti, Zr, Y, Al and Si is contained, and in a case where a total amount of the additive metal is defined as M (atom%) and an amount of tungsten is defined as W (atom%), M/(W + M) is 0.1 or more. Accordingly, it is possible to improve alkali resistance of the formed oxide film. In addition, since M/(W + M) is 0.67 or less, it is possible to suppress the occurrence of abnormal discharge due to the oxide of the additive metal.

[Advantageous Effects of Invention]

According to the present invention, it is possible to provide a tungsten oxide sputtering target capable of suppressing occurrence of cracks and stably performing sputtering film formation for a long period of time, although the sputtering is performed under high power conditions.

[Brief Description of Drawings]

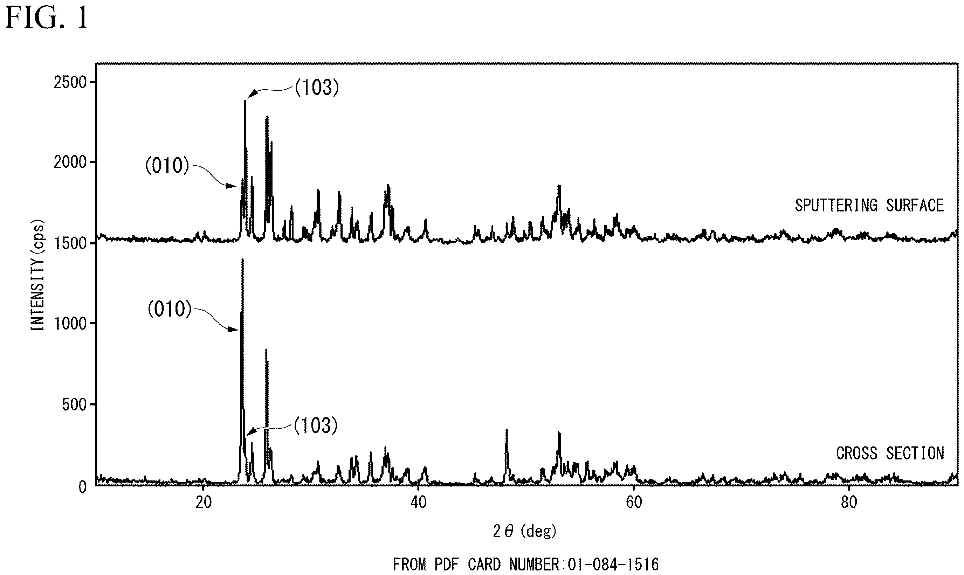

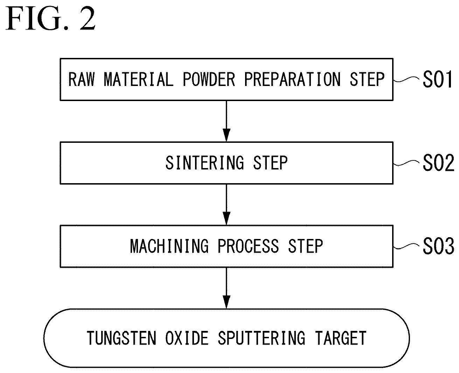

Fig. 1 is a diagram showing an X-ray diffraction analysis result of a sputtering surface of a tungsten oxide sputtering target and a cross section orthogonal to the sputtering surface according to an embodiment of the present invention. Fig. 2 is a flowchart showing a method for manufacturing the tungsten oxide sputtering target according to an embodiment of the present invention.

[Description of Embodiments]

Hereinafter, the tungsten oxide sputtering target according to the embodiment of the present invention will be described with reference to the accompanying drawings.

In the tungsten oxide sputtering target according to the present embodiment, the $W_{18}O_{49}$ peak is confirmed by the X-ray diffraction analysis on the sputtering surface and the cross section orthogonal to the sputtering surface, and the area ratio of the $W_{18}O_{49}$ phase of the surface parallel to the sputtering surface is 37% or more.

In the tungsten oxide sputtering target according to the present embodiment, as shown in Fig. 1, as a result of the X-ray diffraction measurement, the ratio $I_{S(113)}/I_{S(010)}$ of the diffraction intensity $I_{S(103)}$ of the (103) plane to the diffraction intensity $I_{S(010)}$ of the (010) plane of $W_{18}O_{49}$ of the sputtering surface is 0.57 or more.

In addition, the ratio $I_{C(103)}/I_{C(010)}$ of the diffraction intensity $I_{C(103)}$ of the (103) plane to the diffraction intensity $I_{C(010)}$ of the (010) plane of $W_{18}O_{49}$ of the cross section orthogonal to the sputtering surface is 0.38 or less.

The tungsten oxide sputtering target of the present embodiment preferably has a composition of $WO_X$ ($2.1 \leq X \leq 2.9$).

It is preferable that, the tungsten oxide sputtering target of the present embodiment contains an oxide of any one or two or more additive metals of Nb, Ta, Ti, Zr, Y, Al and Si, and as a metal component, in a case where a total amount of the additive metal is defined as M (atom%) and an amount of tungsten is defined as W (atom%), M/(W + M) is in a range of 0.1 or more and 0.67 or less.

In the tungsten oxide sputtering target according to the present embodiment, regarding the ratio $I_{S(103)}/I_{S(010)}$ of the diffraction intensity $I_{S(103)}$ of the (103) plane to the diffraction intensity $I_{S(010)}$ of the (010) plane of $W_{18}O_{49}$ of the sputtering surface, the ratio $I_{C(103)}/I_{C(010)}$ of the diffraction intensity $I_{C(103)}$ of the (103) plane to the diffraction intensity $I_{C(010)}$ of the (010) plane of $W_{18}O_{49}$ of the cross section orthogonal to the sputtering surface, the area ratio of the $W_{18}O_{49}$ phase of the surface parallel to the sputtering surface, and the composition, the reasons for defining as described above will be described.

(Diffraction intensity ratio $I_{S(103)}/I_{S(010)}$ of sputtering surface)

Since the (103) plane of $W_{18}O_{49}$ is harder than the planes of other orientations, it is possible to suppress the occurrence of cracks by controlling the crystal orientation so that the (103) plane is strongly oriented on the sputtering surface.

Therefore, in the present embodiment, the ratio $I_{S(103)}/I_{S(010)}$ of the diffraction intensity $I_{S(103)}$ of the (103) plane to the diffraction intensity $I_{S(010)}$ of the (010) plane of $W_{18}O_{49}$ of the sputtering surface is set as 0.57 or more.

The ratio $I_{S(103)}/I_{S(010)}$ of the diffraction intensity $I_{S(103)}$ of the (103) plane to the diffraction intensity $I_{S(010)}$ of the (010) plane of $W_{18}O_{49}$ of the sputtering surface is preferably 1.2 or more and more preferably 2.02 or more. In addition, an upper limit of $I_{S(103)}/I_{S(010)}$ is not particularly limited, and is preferably 2.56 or less.

(Diffraction intensity ratio $I_{C(103)}/I_{C(010)}$ of cross section orthogonal to sputtering surface)

As the sputtering proceeds, an erosion portion is formed on the sputtering surface. In a case where the orientation of the (103) plane of $W_{18}O_{49}$ is low on the cross section orthogonal to the sputtering surface, although the sputtering has proceeded, a state in which the (103) plane is strongly oriented on the sputtering surface is maintained. Accordingly, it is possible to suppress the occurrence of cracks even after the sputtering has proceeded.

Therefore, in the present embodiment, the ratio $I_{C(103)}/I_{C(010)}$ of the diffraction intensity $I_{C(103)}$ of the (103) plane to the diffraction intensity $I_{C(010)}$ of the (010) plane of $W_{18}O_{49}$ of the cross section orthogonal to the sputtering surface is set as 0.38 or less.

The ratio $I_{C(103)}/I_{C(010)}$ of the diffraction intensity $I_{C(103)}$ of the (103) plane to the diffraction intensity $I_{C(010)}$ of the (010) plane of $W_{18}O_{49}$ of the cross section orthogonal to the sputtering surface is preferably 0.30 or less and more preferably 0.18 or less. In addition, a lower limit of $I_{C(103)}/I_{C(010)}$ is not particularly limited, and is preferably 0.13 or more.

(Area ratio of $W_{18}O_{49}$ phase on surface parallel to sputtering surface)

Since the $W_{18}O_{49}$ phase of tungsten oxide has high conductivity, it is possible to improve the conductivity by ensuring the area ratio of the $W_{18}O_{49}$ phase and to form a tungsten oxide film stably by the DC sputtering.

Therefore, in the present embodiment, the area ratio of the $W_{18}O_{49}$ phase on the surface parallel to the sputtering surface is set to 37% or more. The area ratio of the $W_{18}O_{49}$ phase on the surface parallel to the sputtering surface can be calculated from an image obtained by performing EPMA analysis on an observation surface of an observation sample. Even in a case where oxides of these additive metals of any one or two or more of Nb, Ta, Ti, Zr, Y, Al, and Si are contained in addition to tungsten oxide, the area ratio of the $W_{18}O_{49}$ phase may be 37% or more with respect to the entire surface parallel to the sputtering surface containing the oxides of these additive elements.

The area ratio of the $W_{18}O_{49}$ phase on the surface parallel to the sputtering surface is preferably 55% or more and more preferably 85% or more. In addition, an upper limit of the area ratio of the $W_{18}O_{49}$ phase on the surface parallel to the sputtering surface is not particularly limited, and is preferably 94% or less.

(Composition)

Since various phases such as a $WO_2$ phase, a $WO_3$ phase, and a $W_{18}O_{49}$ phase are mixed in tungsten oxide, a ratio of tungsten and oxygen is defined as $WO_X$.

By setting X to 2.1 or more, the ratio of the $WO_2$ phase can be suppressed, and the $W_{18}O_{49}$ phase having

excellent conductivity can be sufficiently ensured. By setting X to 2.9 or less, the ratio of the $WO_3$ phase can be suppressed, and the $W_{18}O_{49}$ phase having excellent conductivity can be sufficiently ensured. That is, by setting X to 2.1 or more and 2.9 or less, the $W_{18}O_{49}$ phase becomes a main phase (matrix), and the conductivity of the sputtering target can be ensured.

A lower limit of X is preferably 2.4 or more. In addition, an upper limit of X is preferably 2.82 or less.

(Oxide of additive metal)

In the formed oxide film, alkali is used as a resist peeling solution during patterning by an etching method. By containing the oxide of additive metal of any one or two or more of Nb, Ta, Ti, Zr, Y, Al, and Si in tungsten oxide, it is possible to improve the alkali resistance of tungsten oxide. Meanwhile, in a case where an amount of the oxide of the additive metal is extremely great, an abnormal discharge may occur during sputtering due to the oxide of the additive metal.

Therefore, in the present embodiment, in a case where an oxide of any one or two or more additive metals of Nb, Ta, Ti, Zr, Y, Al and Si is contained, in a case where a total amount of the additive metal is defined as M (atom%) and an amount of tungsten is defined as W (atom%) as the metal component, M/(W + M) is regulated in a range of 0.1 or more and 0.67 or less.

A lower limit of M/(W + M) is preferably 0.15 or more and more preferably 0.2 or more. On the other hand, an upper limit of M/(W + M) is preferably 0.5 or less and more preferably 0.4 or less.

Next, a method for manufacturing the tungsten oxide sputtering target according to the present embodiment will be described with reference to Fig. 2.

As shown in Fig. 2, the method for manufacturing the tungsten oxide sputtering target according to the present embodiment includes a raw material powder preparation step S01, a sintering step S02 for sintering the raw material powder, and a machining process step S03 of machining the obtained sintered body.

(Raw material powder preparation step S01)

By reducing the $WO_3$ powder, a WOx powder containing the $WO_2$ powder and the $W_{18}O_{49}$ powder is obtained. This WOx powder may contain a $WO_3$ powder. A purity of WOx powder is 99.9 mass% or more. The X of the WOx powder is controlled by adjusting the conditions of the reduction treatment.

As the reduction treatment, for example, the $WO_3$ powder is heated in a hydrogen atmosphere for a predetermined time at a predetermined temperature to reduce hydrogen. In this hydrogen reduction, the reduction proceeds in the order of $WO_3$ to $WO_{2.9}$, $WO_{2.72}$, $WO_2$, and W. By controlling the proceeding situation of the reduction, it is possible to prepare powders in a mixed state having the composition having different reduction states, and to finely fluctuate an X value of the WOx powder.

In addition, as a method for controlling and finely adjusting the X value of the WOx powder, a powder formed of $WO_3$, $WO_{2.9}$, $WO_{2.72}$, $WO_2$, and W can be appropriately mixed with the powder subjected to the reduction treatment as described above.

In the quantitation of the X in WOx, the sampled WOx is weighed, then heat-treated at 800°C for 1 hour in the atmosphere, and the weight is measured after the heat treatment. Then, it is confirmed that all of them are $WO_3$ by X-ray diffraction analysis, and a W amount is calculated by the following formula. Then, a ratio of oxygen is calculated as the X from the obtained W amount.

$$\text{Weight of W} = \text{Weight after heat treatment} \times M_W/M_{WO3}$$

$$W \text{ (mass\%)} = (\text{weight of W/weight of WO}_X \text{ before heat treatment}) \times 100$$

Mw: Atomic weight of W (183.85), $M_{WO3}$: Atomic weight of $WO_3$ (231.85)

The raw material powder is obtained by mixing the obtained WOx powder. As a mixing method, for example, a dry ball mill using zirconia balls can be used. The mixing method is not limited, and a mixer or a blender, specifically, Henschel, rocking, a recon, or the like can be applied.

An average particle diameter of the raw material powder is preferably in a range of 1 $\mu$m or more and 30 $\mu$m or less.

In a case where the oxide of additive metals of any one or two or more of Nb, Ta, Ti, Zr, Y, Al, and Si is added, various oxide powders are mixed with the WOx powder described above. As a mixing method, for example, a dry ball mill using zirconia balls can be used. The mixing method is not limited, and a mixer or a blender, specifically, Henschel, rocking, a recon, or the like can be applied.

In addition, the oxide powder of the additive metal preferably has a greater particle diameter than that of the WOx powder so as not to disturb the sintering of the WOx powders.

(Sintering step S02)

Next, the raw material powder described above is sintered by pressurizing and heating to obtain a sintered body. In the present embodiment, the sintering was performed in vacuum using a hot press device.

A sintering temperature in the sintering step S02 is in a range of 850°C or higher and 1,400°C or lower, a holding time at the sintering temperature is in a range of 1 hour or longer and 4 hours or shorter, and a pressurizing pressure is in a range of 10 MPa or more and 35 MPa or less.

In the present embodiment, the crystal orientation of the sintered body is controlled by controlling the temperature as follows in the sintering step S02.

First, before starting the temperature rise, the pressurization is performed at the pressurizing pressure described above, and the temperature is raised at a temperature rise rate in a range of 5°C/min or more and 20°C/min or less. Then, it is held at an intermediate temperature in a range of 586°C or higher and 750°C or less in a range of 1 hour or longer and 2 hours or shorter. After that, the sintering is performed by raising the temperature to the sintering temperature described above and holding the temperature.

Accordingly, the (103) plane of $W_{18}O_{49}$ is strongly oriented on a pressurizing surface (surface orthogonal to a pressurizing direction), and the (010) plane of $W_{18}O_{49}$ is strongly oriented on a surface orthogonal to the pressurizing surface (surface along the pressurizing direction).

A lower limit of the intermediate temperature described above is preferably 600°C or higher, and an upper limit of the intermediate temperature is preferably 700°C or lower.

(Machining process step S03)

Next, the obtained sintered body is machined to have a predetermined dimension. At this time, the machining is performed so that the pressurizing surface is a sputtering surface.

Accordingly, the tungsten oxide sputtering target of the present embodiment is manufactured.

According to the tungsten oxide sputtering target of the present embodiment having the configuration described above, the $W_{18}O_{49}$ peak is confirmed by the X-ray diffraction analysis on the sputtering surface and the cross section orthogonal to the sputtering surface, and the area ratio of $W_{18}O_{49}$ phase of the surface parallel to the sputtering surface is 37% or more. Accordingly, it is possible to ensure conductivity and stably perform DC sputtering. In addition, it is possible to ensure the hardness of the tungsten oxide sputtering target.

In the tungsten oxide sputtering target of the present embodiment, the ratio $I_{S(103)}/I_{S(010)}$ of the diffraction intensity $I_{S(103)}$ of the (103) plane to the diffraction intensity $I_{S(010)}$ of the (010) plane of $W_{18}O_{49}$ of the sputtering surface is 0.57 or more, the ratio $I_{C(103)}/I_{C(010)}$ of the diffraction intensity $I_{C(103)}$ of the (103) plane to the diffraction intensity $I_{C(010)}$ of the (010) plane of $W_{18}O_{49}$ of the cross section orthogonal to the sputtering surface is 0.38 or less, and the (103) plane of $W_{18}O_{49}$ is strongly oriented on the sputtering surface. Accordingly, it is possible to suppress the occurrence of cracks, although the high power is applied. In addition, even when the sputtering proceeds and the erosion portion is formed, the crystal orientation on the sputtering surface is maintained, and the occurrence of cracks can be suppressed, even when a high power is applied.

Further, in the tungsten oxide sputtering target of the present embodiment, in a case where the composition is WOx ($2.1 \le X \le 2.9$), the presence of a large amount of $WO_2$ phase or $WO_3$ phase is suppressed, and it is possible to sufficiently ensure the $W_{18}O_{49}$ phase and more stably perform the DC sputtering. In addition, it is possible to sufficiently ensure the hardness of the tungsten oxide sputtering target.

In addition, the tungsten oxide sputtering target of the present embodiment contains an oxide of any one or two or more additive metals of Nb, Ta, Ti, Zr, Y, Al and Si, and in a case where a total amount of the additive metal is defined as M (atom%) and an amount of tungsten is defined as W (atom%), M/(W + M) is in a range of 0.1 or less 0.67 and less. In this case, it is possible to improve the alkali resistance of the formed oxide film and suppress the occurrence of abnormal discharge due to the oxide of the additive metal.

The embodiments of the present invention have been described as above, but the present invention is not limited thereto, and can be appropriately changed without departing from the technical ideas of the present invention.

[Examples]

Hereinafter, a result of an evaluation test for evaluating an action effect of the tungsten oxide sputtering target according to the present invention will be described.

First, the WOx powder was produced by hydrogen-reduction treatment of the $WO_3$ powder described above. In this example, the WOx powders having different x values were prepared by adjusting a degree of reduction. An average particle diameter of the raw material powder was 2.4 $\mu$m.

In addition, as the oxide powders of various additive metals, a $Nb_2O_5$ powder (purity: 99.9 mass%, particle diameter D50: 4.6 $\mu$m), a $Ta_2O_5$ powder (purity: 99.9 mass%, particle diameter D50: 3.5 $\mu$m), a $TiO_2$ powder (purity: 99.9 mass%, particle diameter D50: 2.6 $\mu$m), a $ZrO_2$ powder (purity: 99.9 mass%, particle diameter D50: 11 $\mu$m), a $Y_2O_3$ powder (purity: 99. 9 mass%, particle diameter D50: 2.3 $\mu$m), an $Al_2O_3$ powder (purity: 99.9 mass%, particle diameter D50: 0.2 $\mu$m), and a $SiO_2$ powder (purity: 99.9 mass%, particle diameter D50: 1.9 $\mu$m) were prepared and mixed with the WOx powder in the formulations shown in Tables 1 and 2.

Using this raw material powder, a sintering step was carried out with an apparatus (method) and under conditions shown in Tables 1 and 2, to obtain a sintered body. In Tables 1 and 2, "HP" indicates hot pressing in a vacuum atmosphere, "HIP" indicates a hot isostatic pressing method, and "atmospheric firing" indicates uniaxial molding in an atmospheric atmosphere.

In "HP", the sintering was carried out under the sintering conditions A to D shown below.

Under the sintering condition A, the temperature was raised at a temperature rise rate of 10°C/min while pressurizing under the pressurizing pressures shown in Tables 1 and 2, and the temperature was held at 600°C (intermediate temperature) for 1 hour. Then, the temperature was raised to the sintering temperature shown in Tables 1 and 2 at a temperature rise rate of 10°C/min, and the temperature was held at the sintering temperature for 2 hours. After that, the pressure was released and the mixture was allowed to cool.

Under the sintering condition B, the temperature was raised at a temperature rise rate of 10°C/min while pressurizing under the pressurizing pressures shown in Tables 1 and 2, and the temperature was held at 700°C (intermediate temperature) for 1 hour. Then, the temperature was raised to the sintering temperature shown in Tables 1 and 2 at a temperature rise rate of 10°C/min, and the temperature was held at the sintering temperature for 2 hours. After that, the pressure was released and the mixture was allowed to cool.

Under the sintering condition C, the temperature was raised to the sintering temperature without holding at the intermediate temperature, and the temperature was held at the sintering temperature for 2 hours. After that, the pressure was released and the mixture was allowed to cool.

Under the sintering condition D, the temperature was raised at a temperature rise rate of 10°C/min while pressurizing under the pressurizing pressures shown in Tables 1 and 2, and the temperature was held at 800°C for 1 hour. Then, the temperature was raised to the sintering temperature shown in Tables 1 and 2 at a temperature rise rate of 10°C/min, and the temperature was held at the sintering temperature for 2 hours. After that, the pressure was released and the mixture was allowed to cool.

In "HIP", a metal can filled with the raw material powder in a vacuum-sealed state was placed in a pressure vessel of a hot isostatic pressing device that carries out a hot isostatic pressing method, and it is held at the pressure, the sintering temperature shown in Figs. 1 and 2 for 2 hours, and the sintering was performed.

In the "atmospheric firing", a die was filled with raw material powder and compression molded by uniaxial molding to obtain a molded body. This molded body was charged into an atmosphere furnace and held at the sintering temperatures shown in Tables 1 and 2 for 20 hours to perform the sintering.

Then, the obtained sintered body was machined to produce a disc-shaped tungsten oxide sputtering target having a diameter of 152.4 mm and a thickness of 6 mm. In the sintered body manufactured by the "HP", the machining was performed so that the pressurizing surface became a sputtering surface.

The obtained tungsten oxide sputtering target was evaluated for the following items.

(Composition of tungsten oxide sputtering target)

A measurement sample was collected from the obtained tungsten oxide sputtering target, this measurement sample was pulverized in a mortar, and X was confirmed by the method for quantifying X of the WOx described above. As a result, it was confirmed that there was no change in X from the blended $WO_x$ powder. The evaluation results are shown in Tables 1 and 2.

Regarding the measurement of the degree of oxidation of Examples 13 to 20 of the present invention to which the oxide of the additive metal is added, first, an observation sample was collected from the obtained tungsten oxide sputtering target, this was embedded in an epoxy resin so that the cross section parallel to the sputtering surface is an observation surface, a polishing treatment was performed, and then, an element distribution image showing composition distribution of the elements was observed by using a field emission type electron probe microanalyzer (EPMA). In addition, in the observation with EPMA, an image of an observation field of view of 0.005 $mm^2$ (magnification: 500 times) was captured. In any five points of a region of the obtained element mapping image of W where W is detected, the quantitative analysis using standard samples of W and O was performed, and an average value of values obtained by measuring the degree of oxidation of W was shown in a column of WOx value of Tables 1 and 2.

In addition, in Examples 13 to 21 of the present invention in which the oxide of the additive metal was added, fragments of the obtained tungsten oxide sputtering target to which the oxide of the additive metal was added were ground in a Menou mortar, and the powder was dissolved with acid or alkali. After that, the amount of the additive metal was measured by an ICP emission analyzer.

(X-ray diffraction analysis of sputtering surface and cross section orthogonal to sputtering surface)

From the obtained tungsten oxide sputtering target, a measurement sample was collected so that the sputtering surface and the cross section orthogonal to the sputtering surface are measurement surfaces, and the measurement surfaces were wet-polished with SiC-Paper (grit180).
The X-ray diffraction analysis was performed under the following conditions by using RINT-ULtima/PC manufactured by Rigaku Denki Co., Ltd.

    Tube: Cu
    Tube voltage: 40 kV
    Tube current: 50 mA
    Scanning range ($2\theta$): 5° to 80°
    Slit size: divergence (DS) 2/3 degree, scattering (SS) 2/3 degree, light receiving (RS) 0.8 mm
    Measurement step width: 0.02 degrees at $2\theta$
    Scan speed: 2 degrees per minute
    Sample table rotation speed: 30 rpm

A surface index of the obtained X-ray diffraction peak was confirmed using a PDF card number: 1-084-1516 ($W_{18}O_{49}$).
The ratio $I_{S(103)}/I_{S(010)}$ of the diffraction intensity $I_{S(103)}$ of the (103) plane to the diffraction intensity $I_{S(010)}$ of the (010) plane of $W_{18}O_{49}$ of the sputtering surface and the ratio $I_{C(103)}/I_{C(010)}$ of the diffraction intensity $I_{C(103)}$ of the (103) plane to the diffraction intensity $I_{C(010)}$ of the (010) plane of $W_{18}O_{49}$ of the cross section orthogonal to the sputtering surface were calculated. The evaluation results are shown in Tables 3 and 4.

(Density)

A density at room temperature was measured from the dimension and weight of the measurement sample. The measurement results are shown in Tables 3 and 4.

(Area ratio of $W_{18}O_{49}$ phase)

First, an observation sample was collected from the obtained tungsten oxide sputtering target, this was embedded in an epoxy resin so that the cross section parallel to the sputtering surface is an observation surface, a polishing treatment was performed, and then, an element distribution image showing composition distribution of the elements was observed by using a field emission type electron probe microanalyzer (EPMA). In addition, in the observation with EPMA, five images of an observation field of view of 0.005 mm$^2$ (magnification: 500 times) were captured, and the area of the $W_{18}O_{49}$ phase observed in the images was measured. The measurement results are shown in Tables 3 and 4.
The area ratio of the $W_{18}O_{49}$ phase can be measured by the following procedures (a) to (e).

(a) The generated phase on the observation surface of the observation sample is confirmed by X-ray diffraction analysis under the conditions described above.
(b) The phase analyzed as $W_{18}O_{49}$ phase in (a) is identified in the observation field of view by element analysis of EPMA.
(c) Five images of the observation field of view of COMPO image (60 $\mu$m $\times$ 80 $\mu$m) having a magnification of 500 times were captured by EPMA.
(d) The $W_{18}O_{49}$ phase identified in (b) is extracted by commercially available image analysis software, and the captured image is converted into a monochrome image and binarized. As the image analysis software, for example, WinRoof Ver. 5.6.2 (manufactured by Mitani Corporation) and the like can be used.
(e) From all the binarized images, a total area of all $W_{18}O_{49}$ phase is calculated and divided by the area of all binarized regions, and the area ratio of the $W_{18}O_{49}$ phase with respect to the entire observation region is calculated.

(Hardness of sputtering surface)

An observation sample was collected from the obtained tungsten oxide sputtering target, and a hardness of the sputtering surface was measured.

The hardness was measured using a Vickers hardness tester under the conditions of a load of 500 gf and a time of 10 seconds. The measurement results are shown in Tables 3 and 4.

(Occurrence state of cracks in sputtering test)

A sputtering test was performed using a DC magnetron sputtering apparatus under the conditions of ultimate vacuum degree of $5 \times 10^{-5}$ Pa or less and sputtering Ar gas pressure of 0.3 Pa.

At this time, the sputtering output was increased by 100 W every 10 minutes from DC 100 W, and the sputtering output in which cracks occurred was confirmed. The evaluation results are shown in Tables 3 and 4.

In Tables 3 and 4, "initial stage" is a result of a sputtering test after performing the pre-sputtering for 1 hour. A "middle stage" is a result of a sputtering test in a state where a depth of the erosion portion reaches 1/2 of a target thickness.

(Alkali resistance)

Using the DC magnetron sputtering device, a 100 nm film was formed on a glass substrate under the conditions of ultimate vacuum degree of $5 \times 10^{-5}$ Pa or less, a sputtering Ar gas pressure of 0.3 Pa, a sputtering output of 300 W, Ar gas of 90 sccm, and oxygen gas of 10 sccm. The obtained film was immersed in a 2.38 mass% aqueous solution of tetramethylammonium hydroxide (TMAH), and the time until the film disappeared was measured and shown in Table 3. In a case where it was 60 seconds or longer, it was determined that the product has alkali resistance that can withstand the wiring step (development of the photoresist step).

[Table 1]

EP 3 940 108 A1

| | | Raw material powder | Oxide of additive metal (mol%) | | | | | | | Sintering step | | | | Sputtering target | |
|---|---|---|---|---|---|---|---|---|---|---|---|---|---|---|---|
| | | $WO_x$ Value of X | $Nb_2O_5$ | $Ta_2O_5$ | $T_1O_2$ | $ZrO_2$ | $Y_2O_3$ | $Al_2O_3$ | $SiO_2$ | Method | Sintering condition | Sintering temperature °C | Pressurizing pressure MPa | $WO_x$ Value of X | M/(W+M) |
| Examples of the present invention | 1 | 2.62 | - | - | - | - | - | - | - | HP | A | 1200 | 20 | 2.62 | - |
| | 2 | 2.62 | - | - | - | - | - | - | - | HP | A | 1200 | 35 | 2.62 | - |
| | 3 | 2.62 | - | - | - | - | - | - | - | HP | A | 1200 | 10 | 2.62 | - |
| | 4 | 2.62 | - | - | - | - | - | - | - | HP | A | 1200 | 8 | 2.62 | - |
| | 5 | 2.40 | - | - | - | - | - | - | - | HP | A | 850 | 20 | 2.40 | - |
| | 6 | 2.40 | - | - | - | - | - | - | - | HP | A | 900 | 20 | 2.40 | - |
| | 7 | 2.40 | - | - | - | - | - | - | - | HP | A | 1200 | 20 | 2.40 | - |
| | 8 | 2.10 | - | - | - | - | - | - | - | HP | A | 1200 | 35 | 2.10 | - |
| | 9 | 2.10 | - | - | - | - | - | - | - | HP | A | 1200 | 10 | 2.10 | - |
| | 10 | 2.82 | - | - | - | - | - | - | - | HP | A | 1200 | 20 | 2.82 | - |
| | 11 | 2.62 | - | - | - | - | - | - | - | HP | B | 1200 | 20 | 2.62 | - |
| | 12 | 2.90 | - | - | - | - | - | - | - | HP | A | 900 | 25 | 2.90 | - |
| | 13 | 2.90 | 10 | - | - | - | - | - | - | HP | A | 900 | 25 | 2.89* | 0.18 |
| | 14 | 2.90 | 25 | - | - | - | - | - | - | HP | A | 900 | 25 | 2.58* | 0.40 |
| | 15 | 2.72 | 50 | - | - | - | - | - | - | HP | A | 900 | 25 | 2.70* | 0.67 |
| | 16 | 2.90 | - | 15 | - | - | - | - | - | HP | A | 1200 | 35 | 2.61* | 0.26 |
| | 17 | 2.72 | - | - | 20 | - | - | - | - | HP | A | 1100 | 35 | 2.63* | 0.15 |
| | 18 | 2.90 | - | - | - | 10 | - | - | - | HP | A | 1100 | 35 | 2.60* | 0.10 |
| | 19 | 2.90 | - | - | - | - | 5 | - | - | HP | A | 1100 | 35 | 2.61* | 0.11 |
| | 20 | 2.90 | - | - | - | - | - | 15 | - | HP | A | 1100 | 35 | 2.62* | 0.26 |
| | 21 | 2.90 | - | - | - | - | - | | 15 | HP | A | 1100 | 35 | 2.82* | 0.14 |

[Table 2]

| | | Raw material powder | Oxide of additive metal (mol%) | | | | | | | | Sintering step | | | | Sputtering target | |
|---|---|---|---|---|---|---|---|---|---|---|---|---|---|---|---|---|
| | | $WO_X$ Value of X | $Nb_2O_5$ | $Ta_2O_5$ | $T_1O_2$ | $ZrO_2$ | $Y_2O_3$ | $Al_2O_3$ | $SiO_2$ | Method | Sintering condition | Sintering temperature °C | Pressurizing pressure MPa | $WO_X$ Value of X | M/(W+M) |
| Comparative example | 1 | 2.62 | - | - | - | - | - | - | - | HP | C | 1200 | 20 | 2.62 | - |
| | 2 | 2.62 | - | - | - | - | - | - | - | HIP | - | 1200 | 98 | 2.62 | - |
| | 3 | 2.62 | - | - | - | - | - | - | - | Atmospheric firing | - | 1200 | - | 3.00 | - |
| | 4 | 2.40 | - | - | - | - | - | - | - | HP | C | 850 | 20 | 2.40 | - |
| | 5 | 2.10 | - | - | - | - | - | - | - | HP | C | 1200 | 10 | 2.10 | - |
| | 6 | 2.06 | - | - | - | - | - | - | - | HP | A | 1200 | 20 | 2.06 | - |
| | 7 | 2.86 | - | - | - | - | - | - | - | HP | A | 1200 | 20 | 2.86 | - |
| | 8 | 2.62 | - | - | - | - | - | - | - | HP | D | 1200 | 20 | 2.62 | - |
| | 9 | 2.62 | - | - | - | - | - | - | - | HIP | - | 1200 | 98 | 2.62 | - |
| | 10 | 2.90 | - | - | 70 | - | - | - | - | HP | A | 1200 | 25 | 2.90 | 0.71 |

[Table 3]

| | | Area ratio of $W_{18}O_{49}$ phase % | Diffraction intensity ratio $I_{S(103)}/I_{S(010)}$ of $W_{18}O_{49}$ phase | | Density g/cm$^3$ | Vickers hardness of sputtering surface Hv | Crack occurrence output in sputtering test | | Alkali resistance of film after atmosphere heat treatment |
|---|---|---|---|---|---|---|---|---|---|
| | | | Sputtering surface $I_{S(103)}/I_{S(010)}$ | Cross section $I_{C(103)}/I_{C(010)}$ | | | Initial stage | Middle stage | |
| Examples of the present invention | 1 | 85 | 2.13 | 0.15 | 8.18 | 943 | None | None | 21 |
| | 2 | 84 | 2.56 | 0.13 | 8.19 | 960 | None | None | 20 |
| | 3 | 86 | 1.34 | 0.35 | 8.02 | 926 | None | None | 19 |
| | 4 | 85 | 0.66 | 0.37 | 8.01 | 922 | None | None | 18 |
| | 5 | 56 | 1.46 | 0.31 | 6.85 | 765 | 900W | 900W | 23 |
| | 6 | 55 | 1.43 | 0.29 | 7.53 | 832 | None | None | 22 |
| | 7 | 56 | 1.45 | 0.30 | 8.68 | 967 | None | None | 21 |
| | 8 | 38 | 1.20 | 0.28 | 9.02 | 915 | None | None | 28 |
| | 9 | 37 | 0.57 | 0.38 | 8.82 | 908 | None | None | 27 |
| | 10 | 94 | 2.02 | 0.18 | 7.82 | 973 | None | None | 18 |
| | 11 | 85 | 2.01 | 0.20 | 8.17 | 937 | None | None | 20 |
| | 12 | 88 | 0.65 | 0.32 | 6.13 | 783 | None | None | 18 |
| | 13 | 80 | 0.63 | 0.31 | 4.05 | 832 | None | None | 450 |
| | 14 | 58 | 0.68 | 0.35 | 3.52 | 888 | None | None | >600 |
| | 15 | 37 | 0.73 | 0.28 | 3.33 | 902 | 900W | 900W | >600 |
| | 16 | 64 | 2.21 | 0.14 | 7.39 | 932 | None | None | >600 |
| | 17 | 89 | 1.12 | 0.24 | 6.74 | 892 | None | None | >600 |
| | 18 | 92 | 1.32 | 0.21 | 7.03 | 843 | None | None | 63 |
| | 19 | 84 | 1.23 | 0.20 | 5.76 | 856 | None | None | 375 |
| | 20 | 74 | 1.18 | 0.24 | 5.57 | 827 | None | None | >600 |
| | 21 | 80 | 1.13 | 0.22 | 5.36 | 787 | None | None | >600 |

[Table 4]

| | | Area ratio of $W_{18}O_{49}$ phase % | Diffraction intensity ratio $I_{S(103)}/I_{S(010)}$ of $W_{18}O_{49}$ phase | | Density g/cm$^3$ | Vickers hardness of sputtering surface Hv | Crack occurrence output in sputtering test | | Alkali resistance of film after atmosphere heat treatment |
|---|---|---|---|---|---|---|---|---|---|
| | | | Sputtering surface $I_{S(103)}/I_{S(010)}$ | Cross section $I_{C(103)}/I_{C(010)}$ | | | Initial stage | Middle stage | |
| Comparative example | 1 | 86 | 1.32 | 1.30 | 8.19 | 904 | 800W | 600W | - |
| | 2 | 85 | 1.68 | 1.63 | 8.20 | 903 | 900W | 700W | - |
| | 3 | 0 | (No corresponding peak) | (No corresponding peak) | 6.98 | 867 | Unable to perform DC sputtering (no conductivity) | | - |
| | 4 | 54 | 0.78 | 0.75 | 6.81 | 653 | 600W | 500W | - |
| | 5 | 35 | 0.48 | 0.43 | 8.83 | 910 | None | 500W | - |
| | 6 | 28 | 0.88 | 0.36 | 8.99 | 990 | Discharge stopped due to great abnormal discharge | | - |
| | 7 | 23 | 2.02 | 0.18 | 7.12 | 610 | Discharge stopped due to great abnormal discharge | | - |
| | 8 | 85 | 1.30 | 0.87 | 5.57 | 450 | 400W | 400W | - |
| | 9 | 85 | 1.61 | 1.62 | 8.17 | 902 | 900W | 700W | - |
| | 10 | 27 | 1.42 | 0.54 | 4.89 | 463 | Discharge stopped due to great abnormal discharge | | - |

In Comparative Example 1, the sintering was performed under the sintering condition C by hot pressing (HP), but the diffraction intensity ratio $I_{C(103)}/I_{C(010)}$ of $W_{18}O_{49}$ of the cross section orthogonal to the sputtering surface was beyond the range of the present invention. Then, in the sputtering test, cracks were confirmed at 800 W at an initial stage and at 600 W at a middle stage when the sputtering has proceeded.

In Comparative Example 2, the sintering was performed by hot isostatic pressing method (HIP), but the diffraction intensity ratio $I_{C(103)}/I_{C(010)}$ of $W_{18}O_{49}$ of the cross section orthogonal to the sputtering surface was beyond the range of the present invention. Then, in the sputtering test, cracks were confirmed at 700 W at the middle stage when the sputtering has proceeded.

In Comparative Example 3, as a result of the atmospheric firing, the $W_{18}O_{49}$ phase was not confirmed, and DC sputtering could not be performed.

In Comparative Example 4, the sintering was performed under the sintering condition C by hot pressing (HP), but the diffraction intensity ratio $I_{C(103)}/I_{C(010)}$ of $W_{18}O_{49}$ of the cross section orthogonal to the sputtering surface was beyond the range of the present invention. Then, in the sputtering test, cracks were confirmed at 600 W at an initial stage and at 500 W at a middle stage when the sputtering has proceeded.

In Comparative Example 5, the sintering was performed under the sintering condition C by hot pressing (HP), but the diffraction intensity ratio $I_{S(103)}/I_{S(010)}$ of $W_{18}O_{49}$ of the sputtering surface and the diffraction intensity ratio $I_{C(103)}/I_{C(010)}$ of $W_{18}O_{49}$ of the cross section orthogonal to the sputtering surface were beyond the range of the present invention. Then, in the sputtering test, cracks were confirmed at 900 W at an initial stage and cracks were confirmed at 500 W at a middle stage when the sputtering has proceeded.

In Comparative Example 6, WOx (X = 2.06) was obtained, the area ratio of the $W_{18}O_{49}$ phase was low as 28%, and abnormal discharge occurred frequently during DC sputtering and the discharge was stopped. Accordingly, the sputtering could not be performed. It is surmised that it is because there was a large amount of $WO_2$ phase.

In Comparative Example 7, WOx (X = 2.86) was obtained, the area ratio of the $W_{18}O_{49}$ phase was low as 23%, and abnormal discharge occurred frequently during DC sputtering and the discharge was stopped. Accordingly, the sputtering could not be performed. It is surmised that it is because there was a large amount of $WO_3$ phase.

In Comparative Example 8, the sintering was performed under the sintering condition D by hot pressing (HP), but the density was low and sufficient sintering could not be performed. In addition, the diffraction intensity ratio $I_{C(103)}/I_{C(010)}$ of $W_{18}O_{49}$ of the cross section orthogonal to the sputtering surface was beyond the range of the present invention. Then, in the sputtering test, cracks were confirmed at 400 W at an initial stage and at 400 W at a middle stage when the sputtering has proceeded.

In Comparative Example 9, the sintering was performed by hot isostatic pressing method (HIP), but the diffraction intensity ratio $I_{C(103)}/I_{C(010)}$ of $W_{18}O_{49}$ of the cross section orthogonal to the sputtering surface was beyond the range of the present invention. Then, in the sputtering test, cracks were confirmed at 700 W at the middle stage when the sputtering has proceeded.

In Comparative Example 10, 70 mol% of $TiO_2$ was contained, the area ratio of the $W_{18}O_{49}$ phase of the surface parallel to the sputtering surface was low as 27%, and abnormal discharge occurred frequently during DC sputtering and the discharge was stopped. Accordingly, the sputtering could not be performed.

In contrast, in Examples 1 to 10 and 12 of the present invention, as a result of the sintering performed under the sintering condition A by hot pressing (HP), the diffraction intensity ratio $I_{S(103)}/I_{S(010)}$ of $W_{18}O_{49}$ of the sputtering surface and the diffraction intensity ratio $I_{C(103)}/I_{C(010)}$ of $W_{18}O_{49}$ of the cross section orthogonal to the sputtering surface were in the ranges of the present invention, and the area ratio of the $W_{18}O_{49}$ phase was also in the range of the present invention. In Examples 1 to 4 and 6 to 12 of the present invention, no crack was confirmed, even in a case where the output was increased to 1000 W at both the initial and middle stages of the sputtering test. In addition, in Example 5 of the present invention, the crack was confirmed at 900 W at both the initial and middle stages of the sputtering test, but it was sufficiently usable.

In addition, in Example 11 of the present invention, as a result of the sintering performed under the sintering condition B by hot pressing (HP), the diffraction intensity ratio $I_{S(103)}/I_{S(010)}$ of $W_{18}O_{49}$ of the sputtering surface and the diffraction intensity ratio $I_{C(103)}/I_{C(010)}$ of $W_{18}O_{49}$ of the cross section orthogonal to the sputtering surface were in the range of the present invention and the area ratio of the $W_{18}O_{49}$ phase was also in the range of the present invention. No crack was confirmed, even in a case where the output was increased to 1000 W at both the initial and middle stages of the sputtering test.

In addition, in Examples 13 to 21 of the present invention, the oxide of the additive metal was added, but the diffraction intensity ratio $I_{S(103)}/I_{S(010)}$ of $W_{18}O_{49}$ of the sputtering surface and the diffraction intensity ratio $I_{C(103)}/I_{C(010)}$ of $W_{18}O_{49}$ of the cross section orthogonal to the sputtering surface were in the range of the present invention and the area ratio of the $W_{18}O_{49}$ phase was also in the range of the present invention. In Examples 13, 14, and 16 to 21 of the present invention, no crack was confirmed, even in a case where the output was increased to 1000 W at both the initial and middle stages of the sputtering test. In addition, in Example 15 of the present invention, the crack was confirmed at 900 W at both the initial and middle stages of the sputtering test, but it was sufficiently usable.

The alkali resistance was greatly improved, compared to Examples 1 to 12 of the present invention in which the oxide of the additive metal was not added.

As described above, according to the examples of the present invention, it was confirmed that it is possible to provide a tungsten oxide sputtering target capable of suppressing occurrence of cracks and stably performing sputtering film formation, although the sputtering is performed under high power conditions.

[Industrial Applicability]

According to the present invention, it is possible to provide a tungsten oxide sputtering target capable of suppressing occurrence of cracks and stably performing sputtering film formation for a long period of time, although the sputtering is performed under high power conditions.

**Claims**

1. A tungsten oxide sputtering target,

   wherein a $W_{18}O_{49}$ peak is confirmed by X-ray diffraction analysis of a sputtering surface and a cross section orthogonal to the sputtering surface,
   a ratio $I_{S(103)}/I_{S(010)}$ of a diffraction intensity $I_{S(103)}$ of a (103) plane to a diffraction intensity $I_{S(010)}$ of a (010) plane of $W_{18}O_{49}$ of the sputtering surface is 0.57 or more,
   a ratio $I_{C(103)}/I_{C(010)}$ of a diffraction intensity $I_{C(103)}$ of the (103) plane to a diffraction intensity $I_{C(010)}$ of the (010) plane of $W_{18}O_{49}$ of the cross section is 0.38 or less, and
   an area ratio of a $W_{18}O_{49}$ phase of a surface parallel to the sputtering surface is 37% or more.

2. The tungsten oxide sputtering target according to Claim 1 having a composition of $WO_X$ ($2.1 \leq X \leq 2.9$).

3. The tungsten oxide sputtering target according to Claim 1 or 2, comprising:

   an oxide of any one or two or more additive metals of Nb, Ta, Ti, Zr, Y, Al and Si,
   wherein, as a metal component, in a case where a total amount of the additive metal is defined as M (atom%) and an amount of tungsten is defined as W (atom%), M/(W + M) is in a range of 0.1 or more and 0.67 or less.

FIG. 1

FIG. 2

| RAW MATERIAL POWDER PREPARATION STEP | S01 |
|---|---|

↓

| SINTERING STEP | S02 |
|---|---|

↓

| MACHINING PROCESS STEP | S03 |
|---|---|

↓

TUNGSTEN OXIDE SPUTTERING TARGET

## INTERNATIONAL SEARCH REPORT

| | International application No. |
|---|---|
| | PCT/JP2020/010729 |

**A. CLASSIFICATION OF SUBJECT MATTER**
C23C 14/34(2006.01)i; C04B 35/453(2006.01)i; H01L 21/285(2006.01)i
FI: C23C14/34 A; C04B35/453; H01L21/285 C

According to International Patent Classification (IPC) or to both national classification and IPC

**B. FIELDS SEARCHED**

Minimum documentation searched (classification system followed by classification symbols)
C23C14/34; C04B35/453; H01L21/285

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)
JSTPlus (JDreamIII); JST7580 (JDreamIII); JSTChina (JDreamIII)

**C. DOCUMENTS CONSIDERED TO BE RELEVANT**

| Category* | Citation of document, with indication, where appropriate, of the relevant passages | Relevant to claim No. |
|---|---|---|
| A | JP 2013-76163 A (MITSUBISHI MATERIALS CORP.) 25.04.2013 (2013-04-25) entire text | 1-3 |
| A | JP 3-150357 A (NIPPON TUNGSTEN CO., LTD.) 26.06.1991 (1991-06-26) entire text | 1-3 |
| A | JP 2011-195442 A (SUMITOMO METAL MINING CO., LTD.) 06.10.2011 (2011-10-06) entire text | 1-3 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 April 220 (10.04.2020) | 21 April 2020 (21.04.2020) |

| Name and mailing address of the ISA/ Japan Patent Office 3-4-3, Kasumigaseki, Chiyoda-ku, Tokyo 100-8915, Japan | Authorized officer Telephone No. |
|---|---|

Form PCT/ISA/210 (second sheet) (January 2015)

**INTERNATIONAL SEARCH REPORT**
Information on patent family members

International application No.

PCT/JP2020/010729

| Patent Documents referred in the Report | Publication Date | Patent Family | Publication Date |
|---|---|---|---|
| JP 2013-76163 A | 25 Apr. 2013 | WO 2013/039251 A1 TW 201326428 A | |
| JP 3-150357 A | 26 Jun. 1991 | (Family: none) | |
| JP 2011-195442 A | 06 Oct. 2011 | US 2007/0187653 A1 entire text WO 2006/025470 A1 EP 1801815 A1 CN 101023498 A KR 10-2007-0048807 A | |

Form PCT/ISA/210 (patent family annex) (January 2015)

**REFERENCES CITED IN THE DESCRIPTION**

**Patent documents cited in the description**

- JP 2019048885 A
- JP 2020039257 A
- JP H11067459 A
- JP H10259054 A
- JP 2013076163 A